# EUROPEAN PATENT SPECIFICATION

(11) **EP 3 722 459 B1**
(45) Date of publication and mention of the grant of the patent: **10.05.2023**
(21) Application number: 20169060.9
(22) Date of filing: 09.04.2020
(51) Int. Cl.: C23C 18/16, C23C 18/30, C23C 18/18, C23C 18/42, C25D 5/10

(54) **GOLD PLATING METHOD AND PLATING FILM**
GOLDPLATTIERUNGSVERFAHREN UND PLATTIERUNGSFILM
PROCÉDÉ DE PLACAGE D'OR ET FILM DE PLACAGE

(30) Priority: 10.04.2019 JP 2019074744
(43) Date of publication of application: 14.10.2020
(73) Proprietor: C. Uyemura & Co., Ltd., Osaka-shi, Osaka 541-0045 (JP)
(72) Inventor: MAEDA, Tsuyoshi, Osaka, 573-0065 (JP); TANABE, Katsuhisa, Osaka, 573-0065 (JP); NISHIMURA, Naoshi, Osaka, 573-0065 (JP); KANEKO, Yohei, Osaka, 573-0065 (JP)
(74) Representative: Müller Hoffmann & Partner

(56) References cited:
- EP-A2- 1 209 958
- CN-A- 106 086 962
- JP-A- 2013 089 630
- US-A1- 2013 130 059

## Description

### BACKGROUND OF THE INVENTION

### Field of the Invention

The present invention relates to a gold plating method and a plating film for wire bonding connection by plating using a silver catalyst on a copper or copper alloy film. The present application claims priority based on Japanese Patent Application No. 2019-074744 filed in Japan on April 10, 2019.

### Description of Related Art

In the past, a gold plating for wire bonding connection is performed after a palladium plating by applying a palladium catalyst by substitution reaction on a copper or copper alloy film. In addition, a gold plating is performed on a copper or copper alloy film, then a palladium plating is performed, and a gold plating is performed again.

For example, in Patent Literature 1, a substituted palladium plating film with a palladium purity of 99.5 wt% or more or an electroless palladium plating film with a palladium purity of 99.5 wt% or more, a substituted gold plating film, and an electroless gold plating film are formed on a copper surface of a terminal for wire bonding, in order to obtain the terminal for wire bonding which is excellent in wire bonding characteristic.

In addition, in Patent Literature 2, a gold plating is performed on a substrate provided with a circuit pattern, then a palladium plating is performed, and a gold plating is performed again, in order to solve a problem of abnormal precipitation by a decrease in stability of an electroless palladium.

In addition, in patent Literature 3, a catalyst-imparting liquid for performing an electroless reduction palladium plating on a copper-based metal, after imparting a gold of 0.05 to 3 mg/dm² as catalyst nuclear metal on the copper-based metal, wherein the catalyst-imparting liquid containing a water-soluble gold compound, a heterocyclic compound having a five-membered ring structure including two or more nitrogen atoms, and a chelating agent having an iminodiacetic acid structure, as constituent components, is used to perform the electroless reduction palladium plating on the copper-based metal to impart a palladium plating film on the copper-based metal.
Patent Literature 1: JP 2005-197442 A
Patent Literature 2: JP 2013-108180 A
Patent Literature 3: JP 5567478 B

Further technological background can be found in JP 2013 089630 A and in EP1209958.

### SUMMARY OF THE INVENTION

However, by the methods described in Patent Literatures 1 to 3, a wire bonding characteristic tends to decrease by a thermal hysteresis by implementation and else. In addition, especially when a film thickness of a gold plating film is thin, a wire bonding characteristic is decreased by the thermal hysteresis.

Here, the purpose of the present invention is to provide a gold plating method and a plating film for preventing a decrease of wire bonding characteristic by a thermal hysteresis by implementation and else. In addition, the purpose of the present invention is to provide a gold plating method and a plating film for preventing a decrease of wire bonding characteristic by a thermal hysteresis by implementation and else, even when a film thickness of a gold plating film is thin.

A gold plating method of the present invention is a gold plating method for wire bonding connection by plating using a silver catalyst on a copper or copper alloy film, comprising: a silver catalyst forming step for forming a silver film as the silver catalyst for forming a palladium film; a palladium film forming step for forming the palladium film on the silver catalyst; a gold plating film forming step for forming a gold plating film on the palladium film, wherein a film thickness of the silver film is 0.05 µm to 0.5 µm, wherein an average crystal particle size of the palladium film is 0.09 µm or more, wherein the average crystal particle size of the film is an average crystal particle size of ten particles selected randomly, by observing a cross section of the film with a scanning electron microscope.

In this way, it is possible to provide a gold plating method for preventing a decrease of wire bonding characteristic by a thermal hysteresis by implementation and else.

In this way, a particle size of palladium will be 0.09 µm or more, so it is possible to prevent a decrease of wire bonding characteristic by preventing palladium particles from diffusing and solid-solving in a gold film by a thermal hysteresis.

In addition, in one embodiment of the present invention, a film thickness of the gold plating film may be 0.2 µm or less. In this way, it is possible to provide a gold plating method for preventing a decrease of wire bonding characteristic by a thermal hysteresis by implementation and else, even when a film thickness of a gold plating film is thin.

In addition, in one embodiment of the present invention, a film thickness of the palladium film may be 0.04 µm to 0.6 µm.

In this way, palladium particles can grow into sufficiently large particle size, so it is possible to prevent a decrease of wire bonding characteristic by preventing palladium particles from diffusing and solid-solving in a gold film by a thermal hysteresis.

In addition, a plating film according to the present invention is a plating film for wire bonding connection by plating using a silver catalyst on a copper or copper alloy film, comprising: the copper or copper alloy film; a silver film as the silver catalyst formed on the copper or copper alloy film; a palladium film formed on the silver catalyst; and a gold film formed on the palladium film, wherein a film thickness of the silver film is 0.05 µm to 0.5 µm, wherein an average crystal particle size of the palladium film is 0.09 µm or more wherein the average crystal particle size of the film is an average crystal particle size of ten particles selected randomly, by observing a cross section of the film with a scanning electron microscope.

In this way, it is possible to provide a plating film for preventing a decrease of wire bonding characteristic by a thermal hysteresis by implementation and else.

In this way, a particle size of palladium will be 0.09 µm or more, so it is possible to prevent a decrease of wire bonding characteristic by preventing palladium particles from diffusing and solid-solving in a gold film by a thermal hysteresis.

In addition, in other embodiment of the present invention, a wire pull average strength after heat treatment may be 10.0 g or more.

In this way, it is possible to provide a plating film sufficiently maintaining a wire bonding strength even after heat treatment.

As explained in the above, according to the present invention, it is possible to provide a gold plating method and a plating film for preventing a decrease of wire bonding characteristic by a thermal hysteresis by implementation and else. In addition, it is possible to provide a gold plating method and a plating film for preventing a decrease of wire bonding characteristic by a thermal hysteresis by implementation and else, even when a film thickness of a gold plating film is thin.

### BRIEF DESCRIPTION OF THE DRAWINGS

FIG. 1 is a flow chart illustrating an outline of a gold plating method relating to one embodiment of the present invention.
FIG. 2 is a schematic view illustrating a sectional view of a plating film relating to other embodiment of the present invention.

### DETAILED DESCRIPTION OF THE INVENTION

Hereinafter, explaining in detail about preferred embodiments of the present invention, with reference to the drawings. In addition, the embodiments explained in below will not unjustly limit the content of the present invention described in claims, and it is not limited that all the structures explained in the embodiments are necessary as means for solving the problem of the present invention.

### [Gold plating method]

A gold plating method relating to one embodiment of the present invention is a method for wire bonding connection by plating using a silver catalyst on a copper or copper alloy film. As mentioned in the above, a wire bonding characteristic tends to decrease by a thermal hysteresis by implementation and else. In addition, especially when a film thickness of a gold plating film is thin, a wire bonding characteristic is decreased by the thermal hysteresis. This is because a wire bonding characteristic is decreased as gold concentration is decreased, by a thermal hysteresis, which causes metal particles of palladium and else to penetrate from a grain boundary of the gold plating film and to diffuse in the gold plating film.

Here, according to the gold plating method relating to one embodiment of the present invention, the above problems can be solved. It is explained in detail below.

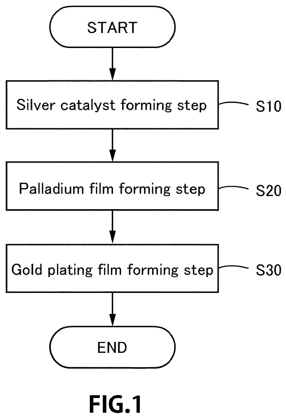

As illustrated in Fig. 1, a gold plating method relating to one embodiment of the present invention comprises: a silver catalyst forming step S10 for forming a silver film as a silver catalyst for forming a palladium film; a palladium film forming step S20 for forming the palladium film on the silver catalyst; a gold plating film forming step S30 for forming a gold plating film on the palladium film, wherein a film thickness of the silver film is 0.05 µm to 0.5 µm.

The gold plating method relating to one embodiment of the present invention comprises the above three steps. In addition, a water washing after the silver catalyst forming step S10, the palladium film forming step S20, and the gold plating film forming step S30, a pre-treatment for forming the silver catalyst, the palladium film and the gold plating film are included in the above steps.

In the silver catalyst forming step S10, the silver film is formed as the silver catalyst for forming the palladium film. The silver catalyst formed in the silver catalyst forming step S10 included in the gold plating method relating to one embodiment of the present invention is used as a catalyst for metal particle (particle size) growth of palladium, which is described in below.

Other metal may be used as a catalyst instead of the silver catalyst, but for example, when palladium catalyst (palladium catalyst is formed, and palladium plating film is formed) is used, each crystal particle size is small, as the palladium film is a precipitation in seed shape. Thus, palladium particles easily enter a grain boundary of the gold plating film, and diffuse and sold-solve in the gold plating film. On the other hand, each crystal particle size of the silver catalyst is large, as the silver film is a precipitation in layer shape. And, by largely grown silver particles, crystals of the palladium film in the following step can also be grown largely. Thus, largely grown palladium particles can no longer easily enter a grain boundary of the gold plating film formed on the palladium film, so it is possible to prevent palladium particles from diffusing and solid-solving into the gold plating film. Therefore, an increase of palladium concentration in the gold plating film is prevented, and gold concentration in the gold plating film will be maintained, so a decrease of wire bonding characteristic is prevented.

Thus, a film thickness of the silver film is 0.05 µm to 0.5 µm. When a film thickness of the silver film is less than 0.05 µm, it will be difficult to form the palladium film in the following palladium film forming step. On the other hand, when a film thickness of the silver film is more than 0.5 µm, a silver particle size will be small, and a particle size of palladium will also be small, so it is not preferable. Therefore, a wire bonding characteristic will be decreased.

An average particle size (hereinafter referred simply as particle size) of the palladium film is 0.09 µm or more, more preferably 0.20 µm or more. In this way, a particle size of palladium will be large as 0.09 µm or more, so palladium particles are prevented from diffusing and solid-solving in a gold film by a thermal hysteresis, and a decrease of wire bonding characteristic is prevented.

In addition, a particle size of a film is an average particle size of ten particles selected randomly, by observing a cross section of a film with a scanning electron microscope (SEM). Same applies to a method for measuring a film indicated in below.

A film thickness of the gold plating film is preferably 0.30 µm or less, and more preferably 0.20 µm or less. In this way, it is possible to provide a gold plating method capable of preventing a decrease of wire bonding characteristic by a thermal hysteresis by an implementation and else, even when a film thickness of the gold plating film is thin. It is because the palladium is prevented from diffusing and solid-solving in the gold plating film.

A film thickness of the palladium film is 0.04 µm to 0.6 µm, and more preferably 0.05 µm to 0.5 µm. In this way, palladium particles can grow into sufficiently large particle size, so palladium particles are prevented from diffusing and solid-solving in a gold film by a thermal hysteresis, and a decrease of wire bonding characteristic is prevented.

In addition, each plating solution used in the silver catalyst forming step S10, the palladium film forming step S20, and the gold plating film forming step S30 may be electrolyte plating or electroless plating, and any of a substitution type, a reduction type, or a substitution reduction type can be selected.

A temperature of heat treatment is 60 to 300°C, preferably 90 to 300°C, and more preferably 100 to 150°C.

In addition, according to need, a cleaner, an etching, and an acid washing step can be added. A medicinal solution used in the cleaner, the etching, and the acid washing step can be selected from a publicly known medicinal solution.

The gold plating method relating to one embodiment of the present invention is especially effective for application on a copper or copper alloy formed as a printed substrate, a BGA substrate, or a package substrate.

From the above, according to the gold plating method relating to one embodiment of the present invention, it is possible to provide a gold plating method capable of preventing a decrease of wire bonding characteristic by a thermal hysteresis by an implementation and else. In addition, it is possible to provide a gold plating method capable of preventing a decrease of wire bonding characteristic by a thermal hysteresis by an implementation and else, even when a film thickness of the gold plating film is thin. Further, according to the gold plating method relating to one embodiment of the present invention, a palladium catalyst is not used, so a silver catalyst is formed only on a copper or copper alloy, and a defect by a short circuit or the like of a gold plating is prevented, so it is also excellent in a fine pattern formation of a circuit.

In addition, compared to a conventional gold plating method, as it does not use a gold catalyst, and as the gold plating film can be formed thin, it is advantageous also in cost. In addition, it is applicable to be cyanogen-free.

### [Plating film]

Next, explaining about a plating film relating to other embodiment of the present invention. A plating film 100 relating to other embodiment of the present invention is a plating film for wire bonding connection by plating using a silver catalyst on a copper or copper alloy film 40.

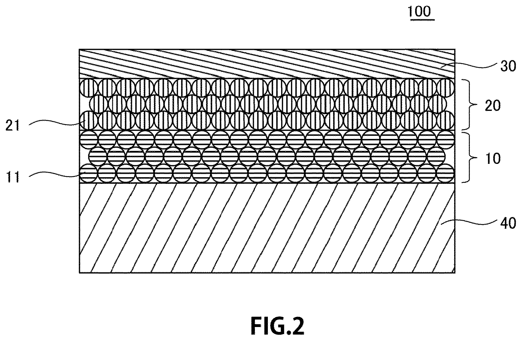

As illustrated in Fig. 2, the plating film relating to other embodiment of the present invention comprises: a copper or copper alloy film 40; a silver film 10 as a silver catalyst formed on the copper or copper alloy film 40; a palladium film 20 formed on the silver catalyst; and a gold film 30 formed on the palladium film 20, wherein a film thickness of the silver film 10 is 0.05 µm to 0.5 µm.

As mentioned in the above, the silver film is a precipitation in layer shape, so each crystal size is large. And, by largely grown silver particles 11, crystals of the palladium film 20 on the silver catalyst can also grow large. Thus, largely grown palladium particles 21 cannot easily enter a grain boundary of the gold film 30 formed on the palladium film 20, and it is possible to prevent the palladium particles 21 from diffusing and solid-solving in the gold film 30. Therefore, an increase of palladium concentration in the gold film 30 is prevented, and gold concentration in the gold film will be maintained, so a decrease of wire bonding characteristic is prevented.

A particle size of the palladium film 20 is preferably 0.09 µm or more, and more preferably 0.20 µm or more. In this way, a particle size of palladium will be large as 0.09 µm or more, so palladium particles 21 are prevented from diffusing and solid-solving in the gold film by a thermal hysteresis, and a decrease of wire bonding characteristic is prevented.

A wire pull average strength after heat treatment is preferably 10.0 g or more. In this way, it is possible to provide a plating film sufficiently maintaining a wire bonding strength even after heat treatment. Here, the heat treatment means a condition that it has been treated at 175°C for 16 hours. In addition, a wire bonding strength of a wire pull average strength is measured using a device of Dage#4000, and by a measuring method of a wire pull test.

From the above, according to the plating film relating to other embodiment of the present invention, it is possible to provide a plating film capable of preventing a decrease of wire bonding characteristic by a thermal hysteresis by an implementation and else. In addition, it is possible to provide a plating film capable of preventing a decrease of wire bonding characteristic by a thermal hysteresis by an implementation and else, even when a film thickness of the gold plating film is thin. Further, according to the plating film relating to other embodiment of the present invention, a palladium catalyst is not used, so a silver catalyst is formed only on a copper or copper alloy, and a defect by a short circuit or the like of a gold plating is prevented, so it is also excellent in a fine pattern formation of a circuit.

Next, explaining in detail about a gold plating method and a plating film relating to one embodiment of the present invention by using examples. In addition, the present invention is not limited to these examples.

### [Example 1]

In an example 1, a BGA substrate made by C. Uyemura & Co., Ltd. applied with a copper film of 5 cm * 5 cm was used as an article to be plated. In a silver catalyst forming step S10, a silver film was formed on the copper film of this substrate, as a silver catalyst for forming a palladium film.

Next, in a palladium film forming step S20, the palladium film was formed on the silver catalyst. In addition, the palladium film was formed by electroless plating.

And, in a gold film forming step S30, a gold plating film was formed on the palladium film. In addition, the gold plating film was formed by electroless plating.

Here, a film thickness of the silver film was 0.05 µm, a film thickness of the palladium film was 0.1 µm, and a film thickness of the gold plating film was 0.1 µm. Also, an average particle size of palladium was 0.25 µm. In addition, a measurement of each film was performed by using a fluorescent X-ray device SFT-9550 (SII). The average particle size of palladium was determined by measuring a cross section of the film with a field emission type scanning electron microscope (FE-SEM) with EBSD detector Digiview5 (EDAX), and by taking an average of 10 particles selected randomly.

As described in the above, the silver film as the silver catalyst, the palladium film, and the gold plating film were formed.

After the above three steps S10, S20 and S30, before and after heat treatment, a wire bonding and wire pull test of the gold plating film were performed, and it was evaluated by obtained wire pull average strength. As a wire bonding device, HB16 (TPT) was used. Bonding conditions were as below. A capillary was B1014-51-18-12 (PECO), and a 1 mil Au wire (SPM) was used as a wire, a stage temperature was 150°C, an ultrasonic wave was 250 mW (1^{st}) and 250 mW (2^{nd}), a bonding time was 200 ms (1^{st}) and 50 ms (2^{nd}), a tensile force was 25 gf (1^{st}) and 50 gf (2^{nd}), a step was 0.7 mm. In addition, a method for measuring a wire bonding strength was a wire pull test, a device was Dage#4000, and a test speed was 170 µm/second.

In this way, a wire pull average strength after forming the gold plating film and before heat treatment was measured. As a result, a wire pull average strength was 10.8 g.

Next, the heat treatment was performed for 16 hours at 175°C, and a wire bonding strength was measured again by the above method, and it was evaluated by a wire pull average strength. As a result, a wire pull average strength was 10.7 g.

### [Example 2]

In an example 2, a film thickness of the silver catalyst was 0.10 µm. In addition, an average particle size of palladium was 0.28 µm. Other steps and conditions were same as the example 1. In addition, a wire pull average strength before heat treatment was 10.3 g, and a wire pull average strength after heat treatment was 10.4 g.

### [Example 3]

In an example 3, a film thickness of the silver catalyst was 0.20 µm. In addition, an average particle size of palladium was 0.30 µm. Other steps and conditions were same as the example 1. In addition, a wire pull average strength before heat treatment was 10.2 g, and a wire pull average strength after heat treatment was 10.3 g.

### [Example 4]

In an example 4, a film thickness of the silver catalyst was 0.30 µm. In addition, an average particle size of palladium was 0.24 µm. Other steps and conditions were same as the example 1. In addition, a wire pull average strength before heat treatment was 10.5 g, and a wire pull average strength after heat treatment was 10.2 g.

### [Example 5]

In an example 5, a film thickness of the silver catalyst was 0.50 µm. In addition, an average particle size of palladium was 0.09 µm. Other steps and conditions were same as the example 1. In addition, a wire pull average strength before heat treatment was 10.4 g, and a wire pull average strength after heat treatment was 10.2 g.

### [Comparative example 1]

In a comparative example 1, a palladium catalyst applying step for applying a palladium catalyst was performed, instead of the silver catalyst forming step S10. In addition, an average particle size of palladium was 0.04 µm. Other steps and conditions were same as the example 1. In addition, a wire pull average strength before heat treatment was 10.4 g, and a wire pull average strength after heat treatment was 7.4 g.

### [Comparative example 2]

In a comparative example 2, the silver catalyst forming step S10 was performed, but a film thickness of the silver catalyst was 0.01 µm. In addition, as a film thickness of the silver catalyst was too thin, a palladium film was not formed. In addition, a wire pull average strength before heat treatment was 10.0 g, and a wire pull average strength after heat treatment was 7.1 g.

### [Comparative example 3]

In a comparative example 3, the silver catalyst forming step S10 was performed, but a film thickness of the silver catalyst was 0.04 µm. In addition, as a film thickness of the silver catalyst was too thin, a palladium film was partially unprecipitated, so it was not able to perform a measurement of the palladium film. In addition, a wire pull average strength before heat treatment was 10.0 g, and a wire pull average strength after heat treatment was 7.0 g.

### [Comparative example 4]

In a comparative example 4, the silver catalyst forming step S10 was performed, but a film thickness of the silver catalyst was 0.55 µm. In addition, an average particle size of palladium was 0.08 µm. Other steps and conditions were same as the example 1. In addition, a wire pull average strength before heat treatment was 10.6 g, and a wire pull average strength after heat treatment was 9.1 g.

### [Comparative example 5]

In a comparative example 5, a film thickness of the silver catalyst was 1.00 µm. In addition, an average particle size of palladium was 0.07 µm. Other steps and conditions were same as the example 1. In addition, a wire pull average strength before heat treatment was 10.5 g, and a wire pull average strength after heat treatment was 8.7 g.

The above conditions and results were illustrated in Table 1.

**[Table 1]**

| | | | Example 1 | Example 2 | Example 3 | Example 4 | Example 5 | Comparative example 1 | Comparative example 2 | Comparative example 3 | Comparative example 4 | Comparative example 5 |
|---|---|---|---|---|---|---|---|---|---|---|---|---|
| Catalyst | Palladium catalyst applying step | | | | | | | ○ | | | | |
| | Silver catalyst forming step S10 | 0.01 um | | | | | | | ○ | | | |
| | | 0.04 um | | | | | | | | ○ | | |
| | | 0.05 um | ○ | | | | | | | | | |
| | | 0.10 um | | ○ | | | | | | | | |
| | | 0.20 um | | | ○ | | | | | | | |
| | | 0.30 um | | | | ○ | | | | | | |
| | | 0.50 um | | | | | ○ | | | | | |
| | | 0.55 um | | | | | | | | | ○ | |
| | | 1.00 um | | | | | | | | | | ○ |
| Pd | Palladium film forming step S20 (Electroless Pd plating) | | ○ | ○ | ○ | ○ | ○ | ○ | Unprecipitated | Partially Unprecipitated | ○ | ○ |
| Au | Gold plating film forming step S30 Electroless Au plating | | ○ | ○ | ○ | ○ | ○ | ○ | ○ | ○ | ○ | ○ |
| | | | | | | | | | | | | |
| Pd crystal particle size | Average particle size | [um] | 0.25 | 0.28 | 0.30 | 0.24 | 0.09 | 0.04 | Unmeasurable | Unmeasurable | 0.08 | 0.07 |
| | | | | | | | | | | | | |
| Wire pull average strength | Without heat treatment | [g] | 10.8 | 10.3 | 10.2 | 10.5 | 10.4 | 10.4 | 10.0 | 10.0 | 10.6 | 10.5 |
| | With heat treatment 175°C - after 16 hours | [g] | 10.7 | 10.4 | 10.3 | 10.2 | 10.2 | 7.4 | 7.1 | 7.0 | 9.1 | 8.7 |

In all examples, there were almost no difference in wire pull average strengths before and after heat treatment, so it was possible to prevent a decrease of wire bonding characteristic by a thermal hysteresis. In addition, when a particle size of the palladium film was 0.09 µm or more, it was possible to prevent a decrease of wire bonding characteristic by a thermal hysteresis. It is considered that this was because the palladium particles were prevented from diffusing and solid-solving in the gold plating film, as the palladium particles could not easily enter a grain boundary of the gold plating film.

On the other hand, in the comparative example 1 in which the silver catalyst forming step S10 was not performed, there was large difference between wire pull average strengths before and after heat treatment, and a wire bonding characteristic was decreased by a thermal hysteresis.

In the comparative examples 2 and 3 in which a film thickness of the silver film as the silver catalyst in the silver catalyst forming step S10 were 0.01 µm and 0.04 µm, as a film thickness of the silver catalyst was too thin, a palladium film was not formed, and a palladium film was unprecipitated or partially unprecipitated, so a wire bonding characteristic was decreased by a thermal hysteresis.

In the comparative examples 4 and 5 in which a film thickness of the silver film as the silver catalyst in the silver catalyst forming step S10 were 0.55 µm and 1.00 µm, a wire bonding characteristic was decreased by a thermal hysteresis. Further, as a film became thicker, an average particle size of palladium became smaller, and a decrease of wire bonding characteristic by a thermal hysteresis became larger. It is considered that this was because a crystal particle size of silver and palladium became smaller by a thickening of a film.

By applying the gold plating method and the plating film relating to the embodiments of the present invention, it is possible to provide a gold plating method and a plating film for preventing a decrease of wire bonding characteristic by a thermal hysteresis by implementation and else. In addition, it is possible to provide a gold plating method and a plating film for preventing a decrease of wire bonding characteristic by a thermal hysteresis by implementation and else, even when a film thickness of a gold plating film is thin.

In addition, it is explained in detail about each embodiment and each example of the present invention as the above, but it can be understood easily for those who skilled in the art that various modifications can be made without practically departing from new matters and effect of the present invention. Therefore, all such variants should be included in the scope of the present invention.

For example, terms described with different terms having broader or equivalent meaning at least once in description and drawings can be replaced with these different terms in any part of description and drawings. In addition, operation and configuration of the gold plating method and the plating film are not limited to those explained in each embodiment and each example of the present invention, and various modifications can be made.

### Glossary of Drawing References

S10 Silver catalyst forming step
S20 Palladium film forming step
S30 Gold plating film forming step
10 Silver film
11 Silver particles
20 Palladium film
21 Palladium particles
30 Gold film
40 Copper or copper alloy film
100 Plating film

## Claims

1. A gold plating method for wire bonding connection by plating using a silver catalyst on a copper or copper alloy film (40), comprising:
a silver catalyst forming step (S10) for forming a silver film (10) as the silver catalyst for forming a palladium film (20);
a palladium film forming step (S20) for forming the palladium film (20) on the silver catalyst;
a gold plating film forming step (s30) for forming a gold plating film (30) on the palladium film (20),
wherein a film thickness of the silver film (10) is 0.05 µm to 0.5 µm,
**characterized in that** an average crystal particle size of the palladium film (20) is 0.09 µm or more, wherein the average crystal particle size of the film is an average crystal particle size of ten particles selected randomly, by observing a cross section of the film with a scanning electron microscope.

2. The gold plating method according to claim 1, wherein a film thickness of the gold plating film (30) is 0.2 µm or less.

3. The gold plating method according to any of claims 1 to 2, wherein a film thickness of the palladium film (20) is 0.04 µm to 0.6 µm.

4. A plating film (100) for wire bonding connection by plating using a silver catalyst on a copper or copper alloy film (40), comprising:
the copper or copper alloy film (40);
a silver film (10) as the silver catalyst formed on the copper or copper alloy film (40);
a palladium film (20) formed on the silver catalyst; and
a gold film (30) formed on the palladium film (20),
wherein a film thickness of the silver film (10) is 0.05 µm to 0.5 µm,
**characterized in that** an average crystal particle size of the palladium film (20) is 0.09 µm or more, wherein the average crystal particle size of the film is an average crystal particle size of ten particles selected randomly, by observing a cross section of the film with a scanning electron microscope.

5. The plating film (100) according to claim 4, wherein a wire pull average strength after heat treatment is 10.0 g or more.

## Patentansprüche

1. Goldplattierungsverfahren für eine Draht-Bonding-Verbindung mittels Plattierung unter Verwendung eines Silberkatalysators auf einem Kupfer- oder Kupferlegierungsfilm (40), aufweisend:
einen einen Silberkatalysator ausbildenden Schritt (S10), um einen Silberfilm (10) als den Silberkatalysator zum Ausbilden des Palladiumfilms (20) auszubilden;
einen einen Palladiumfilm ausbildenden Schritt (S20), um den Palladiumfilm (20) auf dem Silberkatalysator auszubilden;
einen einen Goldplattierungsfilm ausbildenden Schritt (S30), um einen Goldplattierungsfilm (30) auf dem Palladiumfilm (20) auszubilden,
wobei eine Filmdicke des Silberfilms (10) 0,05 *µ*m bis 0,5 *µ*m beträgt,
**dadurch gekennzeichnet, dass** eine durchschnittliche Kristallteilchengröße des Palladiumfilms (20) 0,09 *µ*m oder mehr beträgt, wobei die durchschnittliche Kristallteilchengröße des Films eine durchschnittliche Kristallteilchengröße von zehn, zufällig ausgewählten Teilchen ist, gemäß einer Betrachtung eines Querschnitts des Films mit einem Rasterelektronenmikroskop.

2. Goldplattierungsverfahren nach Anspruch 1, wobei eine Filmdicke des Goldplattierungsfilms (30) 0,2 *µ*m oder weniger beträgt.

3. Goldplattierungsverfahren nach einem der Ansprüche 1 bis 2, wobei eine Filmdicke des Palladiumfilms (20) 0,04 *µ*m bis 0,6 *µ*m beträgt.

4. Plattierungsfilm (100) für eine Draht-Bonding-Verbindung mittels Plattierung unter Verwendung eines Silberkatalysators auf einem Kupfer- oder Kupferlegierungsfilm (40), aufweisend:
den Kupfer- oder Kupferlegierungsfilm (40);
einen Silberfilm (10) als den Silberkatalysator, der auf dem Kupfer- oder Kupferlegierungsfilm (40) ausgebildet ist;
einen Palladiumfilm (20), der auf dem Silberkatalysator ausgebildet ist; und
einen Goldfilm (30), der auf dem Palladiumfilm (20) ausgebildet ist,
wobei eine Filmdicke des Silberfilms (10) 0,05 *µ*m bis 0,5 *µ*m beträgt,
**dadurch gekennzeichnet, dass** eine durchschnittliche Kristallteilchengröße des Palladiumfilms (20) 0,09 *µ*m oder mehr beträgt, wobei die durchschnittliche Kristallteilchengröße des Films eine durchschnittliche Kristallteilchengröße von zehn, zufällig ausgewählten Teilchen ist, gemäß einer Betrachtung eines Querschnitts des Films mit einem Rasterelektronenmikroskop.

5. Plattierungsfilm (100) nach Anspruch 4, wobei eine durchschnittliche Drahtzugfestigkeit nach einer Wärmebehandlung 10,0 g oder mehr beträgt.

## Revendications

1. Procédé de placage en or pour connexion par soudure de fils par placage à l'aide d'un catalyseur d'argent sur un film de cuivre ou d'alliage de cuivre (40), comprenant :
une étape de formation de catalyseur d'argent (S10) pour former un film d'argent (10) comme catalyseur d'argent pour former un film de palladium (20) ;
une étape de formation de film de palladium (S20) pour former le film de palladium (20) sur le catalyseur d'argent ;
une étape de formation de film de placage d'or (S30) pour former un film de placage d'or (30) sur le film de palladium (20),
dans lequel une épaisseur de film du film d'argent (10) est de 0,05 µm à 0,5 µm,
**caractérisé en ce qu'**une taille de particule de cristal moyenne du film de palladium (20) est de 0,09 µm ou plus, dans lequel la taille de particule de cristal moyenne du film est une taille de particule de cristal moyenne de dix particules sélectionnées au hasard, en observant une section transversale du film avec un microscope électronique à balayage.

2. Procédé de placage en or selon la revendication 1, dans lequel une épaisseur de film du film de placage en or (30) est de 0,2 µm ou moins.

3. Procédé de placage en or selon l'une quelconque des revendications 1 à 2, dans lequel une épaisseur de film du film de palladium (20) est de 0,04 µm à 0,6 µm.

4. Film de placage (100) pour connexion par soudure de fils par placage à l'aide d'un catalyseur d'argent sur un film de cuivre ou d'alliage de cuivre (40), comprenant :
le film de cuivre ou d'alliage de cuivre (40) ;
un film d'argent (10) comme catalyseur d'argent formé sur le film de cuivre ou d'alliage de cuivre (40) ;
un film de palladium (20) formé sur le catalyseur d'argent ; et
un film de placage d'or (30) formé sur le film de palladium (20),
dans lequel une épaisseur de film du film d'argent (10) est de 0,05 µm à 0,5 µm,
**caractérisé en ce qu'**une taille de particule de cristal moyenne du film de palladium (20) est de 0,09 µm ou plus, dans lequel la taille de particule de cristal moyenne du film est une taille de particule de cristal moyenne de dix particules sélectionnées au hasard, en observant une section transversale du film avec un microscope électronique à balayage.

5. Film de placage (100) selon la revendication 4, dans lequel une résistance moyenne à la traction de fil après traitement thermique est de 10,0 g ou plus.
